**Europäisches Patentamt**

**European Patent Office**

**Office européen des brevets**

(19)

(11) Veröffentlichungsnummer: **0 302 002**
**B1**

(12) **EUROPÄISCHE PATENTSCHRIFT**

(45) Veröffentlichungstag der Patentschrift:
**27.12.90**

(21) Anmeldenummer: **88730153.9**

(22) Anmeldetag: **05.07.88**

(51) Int. Cl.⁵: **H03M 1/16, H03M 1/82**

(54) Verfahren zum Umsetzen eines analogen Eingangssignals in ein digitales Ausgangssignal.

(30) Priorität: **30.07.87 DE 3725875**

(43) Veröffentlichungstag der Anmeldung:
**01.02.89 Patentblatt 89/5**

(45) Bekanntmachung des Hinweises auf die Patenterteilung:
**27.12.90 Patentblatt 90/52**

(84) Benannte Vertragsstaaten:
**DE FR GB IT NL SE**

(56) Entgegenhaltungen:
**ELEKTRONIK, Band 29, Nr. 17, August 1980,**
**Seiten 67-68; J. KÜHLWETTER: "Ein hochauflösender,**
**schneller A/D-Umsetzer"**
**RADIO FERNSEHEN ELEKTRONIK, Band 32, Nr. 4, 1983,**
**Seiten 220-226; W. FIEGENBAUM:**
**"Präzisions-A-D-Umsetzer mit interner Selbsteichung"**

(73) Patentinhaber: **Siemens Aktiengesellschaft,**
**Wittelsbacherplatz 2, D-8000 München 2(DE)**

(72) Erfinder: **Buchholz, Udo-Fritz, Dipl.-Ing., Wiener**
**Strasse 60, D-1000 Berlin 36(DE)**

**Beschreibung**

Die Erfindung bezieht sich auf ein Verfahren zum Umsetzen eines analogen Eingangssignals in ein digitales Ausgangssignal, bei dem ein Digitalsignal eines mit dem Eingangssignal beaufschlagten internen A/D-Umsetzers rückgekoppelt wird über einen Mikrocomputer und über einen diesem nachgeordneten D/A-Umsetzer, der ein vom Mikrocomputer auf das Digitalsignal des internen A/D-Umsetzers bezogenes Ausgangssignal in ein Analogsignal umsetzt, das über einen vom analogen Eingangssignal gespeisten Differenzverstärker wieder dem internen A/D-Umsetzer zugeführt wird.

Bei einem solchen, beispielsweise aus dem Aufsatz "Towards the accurate digitisation of smoothly varying waveforms" von J. R. Stockton, England (J. Phys. E: Sci. Intrum. 20 (1987), Seiten 33 bis 39) bekannten Verfahren wird das Ausgangssignal des Mikrocomputers durch Extrapolations-Algorithmen ermittelt, indem für einen beispielsweise zu einem Zeitpunkt $t_x$ abgetasteten Wert des analogen Eingangssignals - bezogen auf das entsprechende Digitalsignal des internen A/D-Umsetzers - vom doppelten Wert des digitalen Ausgangssignals zum Zeitpunkt $t_{x-1}$ der Wert des digitalen Ausgangssignals zum Zeitpunkt $t_{x-2}$ subtrahiert wird. Mit dem Ausgangssignal des Mikrocomputers wird also eine "digitale Vorhersage" für den umzusetzenden Abtastwert des Eingangssignals zum Zeitpunkt $t_x$ aus den digitalen Ausgangswerten zu den vergangenen Zeitpunkten $t_{x-1}$ und $t_{x-2}$ getroffen, die dann jedoch noch entsprechend durch Differenzbildung zum analogen Eingangssignal zum Zeitpunkt $t_x$ korrigiert werden muß. Damit die die Korrektur darstellende Differenz - zumal noch verstärkt - jedoch im Umsetzungsbereich des A/D-Umsetzers bleibt, muß die digitale Vorhersage relativ genau zutreffen. Als Voraussetzung für die Anwendungsmöglichkeit eines solchen Verfahrens unter Verwendung von Extrapolationsalgorithmen muß deshalb ein möglichst gleichmäßiger und vor allem sinusförmiger Verlauf des analogen Eingangssignals vorliegen.

Eine weitere, allgemeingültige Voraussetzung für die Anwendung solcher gattungsgemäßer rückgekoppelter Umsetzungsverfahren ist, daß der D/A-Umsetzer zwar nur eine Auflösung von der Größe der Auflösung des internen A/D-Umsetzers aufweisen muß, die Einhaltung seiner einzelnen Umsetzungsstufen jedoch mit einer Genauigkeit erfolgen muß, die der Gesamtgenauigkeit des Verfahrens, mit der das analoge Eingangssignal in das digitale Ausgangssignal umgesetzt wird, entspricht. Diese Gesamtgenauigkeit ist - das ist das Ziel des Verfahrens - jedoch sehr hoch. Für ein solches Verfahren sind daher nur wenige D/A-Umsetzer, die zumeist entsprechend kompliziert aufgebaut sind, geeignet (siehe Dr. W.-D. Schleifer "Keine Angst vor Stufen", 2. Teil, Elektronik 8/16.04.87, Seite 88).

Erfindungsgemäß besteht die Aufgabe, eine Umsetzung von in ihrem zeitlichen Verlauf beliebigen analogen Eingangssignalen in digitale Ausgangssignale mit hochgenauer Umsetzungsqualität zu ermöglichen, bei der der D/A-Umsetzer möglichst einfach aufgebaut werden kann.

Erfindungsgemäß wird diese Aufgabe dadurch gelöst, daß
- der D/A-Umsetzer einen von einer Konstantspannungsquelle über einen Widerstand aufladbaren Kondensator enthält und
- die Ladezeit des Kondensators vom Mikrocomputer über ein das Ein- oder Mehrfache seiner konstanten Steuertaktzeit betragendes, in Abhängigkeit vom Wert des Digitalsignals gebildetes Schaltsignal gesteuert wird.

Das erfindungsgemäße Verfahren macht von einem einfachen Kondensator Gebrauch, bei dem das Aufladen in Abhängigkeit des Ein- oder Mehrfachen der hochpräzisen Steuertaktzeit des Mikrocomputers erfolgt. Wenn also der Kondensator durch das Schaltsignal, welches beispielsweise einen an eine Konstantspannungsquelle angeschlossenen Schalter entsprechend steuert, während einer extrem genau bestimmten Ladezeit aus der Konstantspannungsquelle über einen Widerstand geladen wird, hat seine Ladespannung, die das analoge Ausgangssignal des D/A-Umsetzers darstellt, mit derselben Genauigkeit danach einen vorbestimmten Wert erreicht. Durch Anwendung der Erfindung ist also eine Genauigkeit erzielbar, die ohne weiteres im Bereich der angestrebten Gesamtgenauigkeit des Umsetzungsverfahrens (14 bis 16 bit) liegt.

Ein wesentlicher Vorteil besteht darin, daß beliebige zeitliche Verläufe des Eingangssignals mit dem erfindungsgemäßen Verfahren verarbeitet werden können, weil das Schaltsignal über das Ausgangssignal des Mikrocomputers direkt in Abhängigkeit vom aktuellen Digitalsignal des internen A/D-Umsetzers gebildet wird. Es wird damit jeweils für den aktuellen umzusetzenden Abtastwert der Eingangsgröße gebildet; "Vorhersagen" entfallen.

Die Abhängigkeit der Bildung des Schaltsignals vom Digitalsignal des internen A/D-Umsetzers ist durch einen vom Mikrocomputer ausgeführten Vergleich der dem analogen Eingangssignal entsprechenden aktuellen Eingangsspannung mit der zu erzeugenden Kondensatorladerspannung in der Weise gegeben, daß die verstärkte Differenz zwischen der aktuellen Eingangsspannung und der Kondensatorladespannung immer genau im Umsetzungsbereich des internen A/D-Umsetzers liegt. Verarbeitet dieser beispielsweise nur positive Differenzsignale als Eingangssignale, so führt der Mikrocomputer den Vergleich so durch, daß die Kondensatorspannung die etwas größere Spannung ist. So ist in diesem Fall gewährleistet, daß das erfindungsgemäße Verfahren im Normalfall stets ein digitales Ausgangssignal liefert, da die zu bildende Differenz bei Anlegen der Kondensatorladespannung an den positiven Eingang des Differenz verstärkers stets größer Null ist.

Nach einer Ausgestaltung des erfindungsgemäßen Verfahrens wird der geladene Kondensator vom Mikrocomputer in einem vorbestimmten Meßdurchgangstakt entladen. Auf diese Art kann in einfacher Weise über den Mikrocomputer dafür gesorgt werden, daß der Kondensator nach für einen Umsetzungsdurchlauf erfolgter Ladung auch jeweils wieder entladen wird, so daß er für den nächsten Umsetzungsdurchlauf bereit ist.

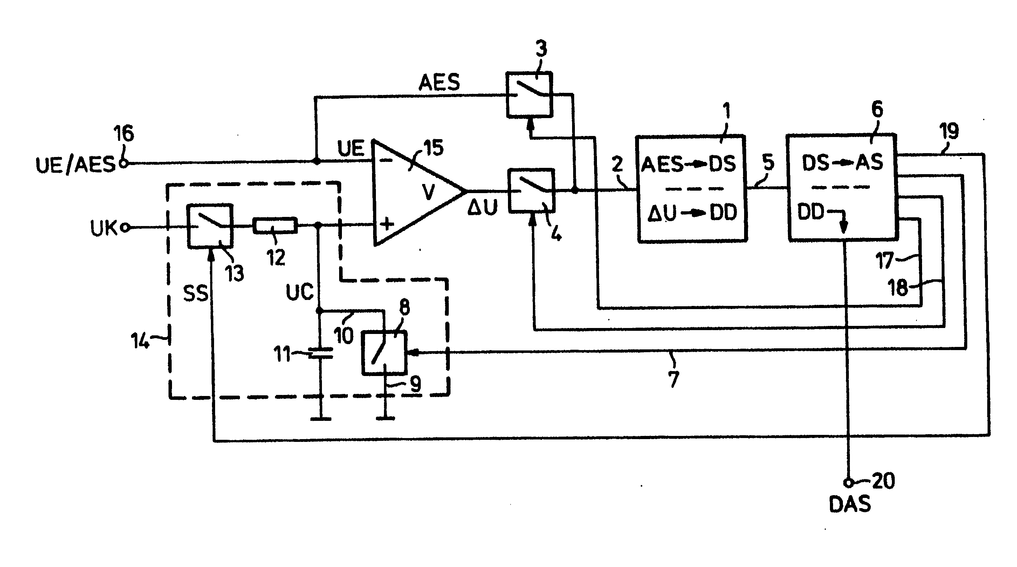

Anhand der Figur wird im folgenden das erfindungsgemäße Verfahren zum Umsetzen eines analogen Eingangssignals in ein digitales Ausgangssignal näher erläutert. Die Figur zeigt den prinzipiellen Aufbau einer bevorzugten Schaltungsanordnung zur Durchführung des erfindungsgemäßen Verfahrens.

In der Figur ist ein interner A/D-Umsetzer 1 dargestellt, dessen Eingang 2 mit einem ersten Schalter 3 und einem zweiten Schalter 4 verbunden ist. An einen Ausgang 5 des internen A/D-Umsetzers 1 ist ein Mikrocomputer 6 angeschlossen. Dieser Mikrocomputer 6 weist eine erste Steuerleitung 7 auf, über die er einen weiteren Schalter 8 steuern kann. Dieser weitere Schalter 8 ist mit seinem Ausgang 9 an Erdpotential gelegt und mit seinem Eingang 10 parallel zu einem Kondensator 11 geschaltet. In Reihe zu diesem Kondensator 11 ist ein Widerstand 12 angeordnet, an den wiederum ein zusätzlicher Schalter 13 angeschlossen ist. Dieser zusätzliche Schalter 13 liegt mit seinem einen Ausgang an einer Konstantspannungsquelle UK. Der Kondensator 11, der weitere Schalter 8 und der zusätzliche Schalter 13 sowie der Widerstand 12 bilden gemeinsam einen D/A-Umsetzer 14.

Der Kondensator 11 ist an einen positiven Eingang eines Differenzverstärkers 15 angeschlossen, dessen negativer Eingang mit einem analogen Eingangssignal AES, welches auf einen Eingang 16 gegeben wird, beaufschlagt wird und dessen Ausgang mit dem zweiten Schalter 4 verbunden ist. Der Mikrocomputer 6 weist neben der ersten Steuerleitung 7 noch eine zweite Steuerleitung 17, über die der erste Schalter 3 gesteuert werden kann, eine dritte Steuerleitung 18, über die der zweite Schalter 4 gesteuert werden kann, und eine vierte Steuerleitung 19 auf, mit der der Mikrocomputer 6 den zusätzlichen Schalter 13 steuern kann. Außerdem besitzt der Mikrocomputer 6 einen anzeigenden Ausgang 20, an dem ein ermitteltes digitales Ausgangssignal DAS angezeigt werden kann.

Im folgenden wird der Ablauf eines Umsetzdurchlaufes, welcher den Meßtakt des Umsetzungsverfahrens bestimmt, nach dem erfindungsgemäßen Verfahren beschrieben. Vor Beginn eines Durchlaufes sind alle Schalter 3, 4, 8 und 13 - wie in der Figur dargestellt - geöffnet. Das gegebenenfalls von einem nicht dargestellten Abtast- und Halteglied abgetastete und auf den Eingang 16 gegebene Eingangssignal AES, welches einer Eingangsspannung UE entspricht, wird - neben seiner ständigen Leitung auf den negativen Eingang des Differenzverstärkers 15 - vom Mikrocomputer 6 auf den Eingang 2 des internen A/D-Umsetzers 1 gegeben, indem der Mikrocomputer 6 über seine zweite Steuerleitung 17 den ersten Schalter 3 zum Schließen veranlaßt. Der interne A/D-Umsetzer 1 ist beispielsweise ein 8 bit-Umsetzer und digitalisiert das Eingangssignal AES mit der entsprechenden Auflösung. Ein so erzeugtes Digitalsignal DS des internen A/D-Umsetzers 1 (in der Figur im oberen Teil des internen A/D-Umsetzers 1 dargestellt) wird dann durch die nachfolgende Schaltungsanordnung rückgekoppelt.

Die Rückkopplung ist eine verfahrensspezifische Eigenschaft. Sie bewirkt, daß die zunächst im internen A/D-Umsetzer 1 durchgeführte "grobe" Umsetzung noch verfeinert, d. h. die Anzahl der angezeigten bits vergrößert wird, indem der unterhalb des zunächst kleinsten angezeigten "groben" bits liegende, noch nicht erfaßte Feinbereich durch Differenzbildung zu einem entsprechenden analogen Eingangssignal gebildeten Analogsignal erfaßt und durch Verstärkung entsprechend gespreizt wird. Die anschließende Digitalisierung im internen A/D-Umsetzer 1 ergibt dann quasi die "Feinumsetzung", deren bit-Zahl einfach an die "grobe" bit-Zahl "angehängt" wird. Eine gegebenenfalls auftretende Überlappung der Grob- und Feinumsetzung wird dabei durch einen Verstärkungsfaktor V des Differenzverstärkers 15 bestimmt.

Innerhalb der Rückkopplung wird das Digitalsignal DS des internen A/D-Umsetzers 1 zunächst auf den Mikrocomputer 6 geleitet. Aufgabe des Mikrocomputers 6 ist es u. a., ein Ausgangsignal AS zu erzeugen, das auf das Digitalsignal DS des internen A/D-Umsetzers 1 bezogen ist. Hierzu ist im Mikrocomputer 6 beispielsweise eine Tabelle abgelegt, in der digitalisierte Werte einer Kondensatorladespannung UC des Kondensators 11 mit den zugehörigen Ladezeiten abgelegt sind. Die Ladezeiten sind dabei so gewählt, daß sie das Ein- oder Mehrfache der konstanten Steuertaktzeit des Mikrocomputers 6 betragen; demgemäß sind auch die einzelnen Ladespannungsstufen UC des Kondensators 11 diskretisiert. Entsprechend dem empfangenen Digitalsignal DS des internen A/D-Umsetzers 1 sucht nun der Mikroprozessor 6 - im beschriebenen Ausführungsbeispiel - denjenigen digitalisierten Wert der Kondensatorladespannung UC in seiner Tabelle auf, der etwas größer ist als das Digitalsignal DS, und entnimmt der Tabelle die zugehörige Ladezeit.

Der Vorgang des Tabellenvergleichs zur Ermittlung der Ladezeit kann selbstverständlich auch durch Berechnung anhand der Formel für die Kondensatorladespannung erfolgen. Vorteil der Tabelle ist es aber, daß die Nichtlinearität beim Aufladen des Kondensators 11 in schneller Weise berücksichtigt werden kann, wobei kleine Änderungen der Zeitkonstanten (Produkt aus Widerstand 12 und Kapazität des Kondensators 11) keine großen Nichtlinearitätsfehler bewirken.

Der diskrete Wert der Ladezeit bildet das Ausgangssignal AS des Mikrocomputers 6, mit dem dieser dann über die vierte Steuerleitung 19 den zusätzlichen Schalter 13 ansteuert. Der zusätzliche Schalter 13 empfängt das Ausgangssignal AS als ein Schaltsignal SS und schließt für die Dauer der gewählten Ladezeit. In der Schließzeit des zusätzlichen Schalters 13 wird der Kondensator 11 über den Widerstand 12 von der Konstantspannungsquelle UK geladen. Da die Ladezeit des Kondensators 11 das Ein- oder Mehrfache der konstanten Steuertaktzeit des Mikrocomputers 6 beträgt und dieser damit die Ladezeit des Kondensators 11 hochpräzise steuern kann, ist gewährleistet, daß auch entsprechend die sich nach der gewählten Ladezeit am Kondensator einstellende Kondensatorladespannung UC mit derselben Präzision erreicht wird.

Beispielsweise kann es sich bei dem den Kondensator 11 enthaltenden D/A-Umsetzer 14 um einen 8 bit-Umsetzer handeln, der also über dieselbe Auflösung verfügt wie der interne A/D-Umsetzer 1. Die einzelnen diskreten Ladespannungswerte UC des Kondensators 11 können aber beispielsweise mit einer 16 bit-Genauigkeit, d. h. auf 16 anzeigende Stellen genau, eingestellt werden, wenn diese entsprechend als 16 bit-Zahlen in der Tabelle des Mikrocomputers 6 abgelegt sind oder deren Berechnung auf 16 bit-Stellen genau erfolgt.

Nach dem Ladevorgang über die präzise einstellbare Ladezeit wird der zusätzliche Schalter 13 vom Mikrocomputer 6 zum Öffnen veranlaßt, und der Kondensator 11 weist eine mit 16 bit genau bestimmte Kondensatorladespannung UC auf, die so vom Mikrocomputer 6 gewählt wurde, daß sie etwas größer ist als der entsprechende Spannungswert UE des abgetasteten analogen Eingangssignals AES. Die Kondensatorladespannung UC wird dann auf den positiven Eingang des Differenzverstärkers 15 geleitet, und da dieser mit seinem negativen Eingang mit dem Abtastwert des analogen Eingangssignals AES beaufschlagt ist, bildet er zwischen beiden eine positive Spannungsdifferenz. Diese Spannungsdifferenz wird von dem Differenzverstärker 15 noch zusätzlich mit dem Verstärkungsfaktor von beispielsweise V = 128 verstärkt. Dieser Verstärkungsfaktor entspricht einer Auflösung von $2^7$ bit, mit der der Differenzverstärker 15 die gebildete Spannungsdifferenz entsprechend spreizt bzw. auffächert.

Der Mikrocomputer 6 steuert dann über die dritte Steuerleitung 18 den zweiten Schalter 4 an, so daß dieser kurzzeitig schließt und die verstärkte Spannungsdifferenz $\Delta U$, nachdem diese sich nach einer entsprechenden Wartezeit stabilisiert hat, wiederum dem internen A/D-Umsetzer 1 zugeführt wird. Der interne A/D-Umsetzer 1 hat beispielsweise die Auflösung von 8 bit, so daß die auf 7 bit aufgefächerte verstärkte Spannungsdifferenz $\Delta U$ des Differenzverstärkers 15 noch einmal mit 8 bit aufgelöst wird, so daß das Umsetzungsverfahren eine Gesamtgenauigkeit von 15 bit aufweist. Mit anderen Worten wird die 8 bit-Genauigkeit des internen A/D-Umsetzers 1 mit der 8 bit-Genauigkeit des D/A-Umsetzers 14 entsprechend dem Verstärkungsfaktor V mit 7 bit in genau einem bit überlappt, so daß die Gesamtgenauigkeit von 15 bit entsteht. Bei einem Verstärkungsfaktor von V = 256 entsprechend 8 bit wäre die Überlappung Null, so daß eine Gesamtgenauigkeit von 16 bit erreicht würde. Bei einem so großen Verstärkungsfaktor würde aber schnell der Umsetzungsbereich des internen A/D-Umsetzers 1 überschritten werden.

Ein vom internen A/D-Umsetzer 1 digitalisiertes Differenzsignal DD (in der Figur im unteren Teil des internen A/D-Umsetzers 1 dargestellt) wird dann dem Mikrocomputer 6 zugeführt, der daraus das dem abgetasteten analogen Eingangssignal AES entsprechende digitale Ausgangssignal DAS berechnet. Für diese Rechnung gilt:
- am Ausgang des Differenzverstärkers 15:

$$\Delta U = V \cdot (UC - UE),$$
- daraus folgt: $UE = UC - \Delta U/V$,
- mit den dem Mikrocomputer bekannten digitalen Werten für UC (Tabelle), $\Delta U$ (DD) und V (27) kann das UE entsprechende digitale Ausgangssignal DAS damit berechnet werden.

Nach der Ermittlung des digitalen Ausgangssignals DAS steuert dann der Mikrocomputer 6 über die erste Steuerleitung 7 den weiteren Schalter 8 an, so daß dieser schließt und der Kondensator 11 entladen wird. Danach öffnet der weitere Schalter 8 wieder, und die gesamte Schaltungsanordnung ist entsprechend des Meßdurchgangstaktes in Bereitschaftsstellung für den nächsten Umsetzungsvorgang.

Statt der in der Figur dargestellten Schalter 3 und 4 und des separaten internen A/D-Umsetzers 1 kann auch ein Mikrocomputer 6 verwendet werden, der das analoge Eingangssignal AES und die verstärkte Spannungsdifferenz $\Delta U$ einem integrierten A/D-Umsetzer 1 über einen Multiplexereingang zuführt. Zur Erzeugung der exakten Kondensatorladezeiten kann der Mikrocomputer 6 einen Zähler mit Vergleichsregistern aufweisen.

Für eine Kompensation bei der Umsetzung auftretender Fehler, insbesondere Langzeiteffekte und Temperaturdrift der Konstantspannungsquelle UK, des Kondensators 11 und des Widerstandes 12 kann bei dem erfindungsgemäßen Verfahren vorgesehen sein, Referenzmessungen mit einer Maximalspannung und mit Nullpotential durchzuführen. Dabei ist es ausreichend, jeweils nach einem Meßdurchgang alternierend immer eine der beiden Referenzmessungen durchzuführen. Die Umschaltung zwischen den einzelnen Eingangssignalen kann ebenfalls vom Mikrocomputer 6 im Meßdurchgangstakt gesteuert werden.

Im Zusammenhang mit einer gegebenenfalls auftretenden Drift der Zeitkonstanten RC und der dadurch hervorgerufenen zeitlichen Veränderung der Linearität der Funktion für die Kondensatorladung ist es weiterhin günstig, wenn der Arbeitsbereich des Kondensators 11 im ersten Viertel seiner Ladekurve liegt, so daß die maximal erreichbare Ladezeit ein Viertel der Zeit konstante RC beträgt.

Schließlich kann in das Programm für den Mikrocomputer 6 zum Durchlaufen eines Meßdurchgangs noch eine Schleife für eine erneute Ladung des Kondensators 11 eingebaut sein für den Fall, daß am Ausgang des Differenzverstärkers 15 Werte für die verstärkte Spannungsdifferenz $\Delta U$ auftreten, die nicht vom internen A/D-Umsetzer 1 umgesetzt werden können.

## Patentansprüche

1. Verfahren zum Umsetzen eines analogen Eingangssignals (AES) in ein digitales Ausgangssignal (DAS), bei dem ein Digitalsignal (DS) eines mit dem Eingangssignal (AES) beaufschlagten internen A/D-Umsetzers (1) rückgekoppelt wird über einen Mikrocomputer (6) und über einen, diesem nachgeordneten D/A-Umsetzer (14), der ein vom Mikrocomputer (6) auf das Digitalsignal (DS) des internen A/D-Umsetzers (1) bezogenes Ausgangssignal

EP 0 302 002 B1

(AS) in ein Analogsignal (UC) umsetzt, das über einen vom analogen Eingangssignal (AES) gespeisten Differenzverstärker (15) wieder dem internen A/D-Umsetzer (1) zugeführt wird, **dadurch gekennzeichnet, daß**
- der D/A-Umsetzer (14) einen von einer Konstantspannungsquelle (UK) über einen Widerstand (12) aufladbaren Kondensator (11) enthält und
- die Ladezeit des Kondensators (11) vom Mikrocomputer (6) über ein das Ein- oder Mehrfache seiner konstanten Steuertaktzeit betragendes, in Abhängigkeit vom Wert des Digitalsignals (DS) gebildetes Schaltsignal (SS) gesteuert wird.

2. Verfahren nach Anspruch 1, **dadurch gekennzeichnet, daß**
- der geladene Kondensator (11) vom Mikrocomputer (6) in einem vorbestimmten Meßdurchgangstakt entladen wird.

**Claims**

1. Method for converting an analogue input signal (AES) into a digital output signal (DAS), wherein a digital signal (DS) from an internal A/D-converter (1) receiving the input signal (AES) is fed back by means of a microcomputer (6) and by means of a D/A-converter (14) arranged thereafter, which converts an output signal (AS), related by the microcomputer (6) to the digital signal (DS) from the internal A/D-converter (1), into an analogue signal (UC), which is supplied again to the internal A/D-converter (1) by means of a difference amplifier (15) supplied with the analogue input signal (AES), characterized in that
− the D/A-converter (14) contains a capacitor (11) which can be charged by a constant voltage source (UK) by means of a resistance (12) and
− the charging time of the capacitor (11) is controlled by the microcomputer (6) by means of a switching signal (SS) of duration equal to, or a multiple of, its constant control clock time and generated in dependence upon the value of the digital signal (DS).

2. Method according to claim 1, characterized in that
− the charged capacitor (11) is discharged by the microcomputer (6) in one predetermined measuring operation clock cycle.

**Revendications**

1. Procédé pour convertir un signal d'entrée analogique (AES) en un signal de sortie numérique (DAS), selon lequel un signal numérique (DS) d'un convertisseur analogique/numérique interne (1), chargé par un signal d'entrée (AES), est couplé par réaction, par l'intermédiaire d'un micro-ordinateur (6) et d'un convertisseur numérique/analogique (14), branché en aval de ce micro-ordinateur et convertissant un signal de sortie (AS) rapporté par le micro-ordinateur (6) au signal numérique (DS) du convertisseur analogique/numérique interne (1), en un signal analogique (UC), qui est à nouveau envoyé au convertisseur analogique/numérique interne (1), par l'intermédiaire d'un amplificateur différentiel (15) alimenté par le signal d'entrée analogique (AES), caractérisé par le fait que
− le convertisseur numérique/analogique (14) comporte un condensateur (11) pouvant être chargé par une source de tension constante (UK), par l'intermédiaire d'une résistance (12), et
− le temps de charge du condensateur (11) est commandé par le micro-ordinateur (6) par l'intermédiaire d'un signal de commutation (SS) égal a la durée de cadence de commande du micro-ordinateur ou à un multiple de cette durée et formé en fonction de la valeur du signal numérique (DS).

2. Procédé suivant la revendication 1, caractérisé par le fait le condensateur chargé (11) est déchargé parle micro-ordinateur (6) selon une cadence d'exécution de mesure prédéterminée.